# EUROPEAN PATENT APPLICATION

(11) **EP 3 429 328 A1**
(43) Date of publication of application: **16.01.2019**
(21) Application number: 17763426.8
(22) Date of filing: 10.03.2017
(51) Int. Cl.: H05K 13/04, H05K 13/08

(54) **ELECTRONIC-COMPONENT MOUNTING DEVICE AND METHOD FOR MOUNTING ELECTRONIC COMPONENT**

(30) Priority: 11.03.2016 JP 2016048099
(71) Applicant: Kawasaki Jukogyo Kabushiki Kaisha, Kobe-shi, Hyogo 650-8670 (JP)
(72) Inventor: HIRATA, Kazunori, Kobe-shi, Hyogo 650-8670 (JP); IWASAKI, Yukio, Kobe-shi, Hyogo 650-8670 (JP)
(74) Representative: Müller-Boré & Partner Patentanwälte PartG mbB
(86) International application number: PCT/JP2017/009722
(87) International publication number: WO 2017/155094

(57) **Abstract**

An electronic-component mounting device (10) is provided with: a gripping portion (29) for holding an electronic component (30) having a lead wire (31); a conveyance portion for conveying the electronic component (30) gripped by the gripping portion (29) onto a substrate (40) to which an insertion hole (41) is provided; and a swinging portion for swinging the electronic component (30) and the substrate (40) relative to each other, the electronic component (30) being released on the substrate (40) from gripping by the gripping portion (29).

## Description

### Technical Field

The present invention relates to an electronic-component mounting device and a method for mounting an electronic component for inserting a lead wire of an electronic component into an insertion hole of an electronic circuit substrate and mounting the electronic component on the electronic circuit substrate.

### Background Art

Conventionally, a lead wire of an electronic component is inserted into an insertion hole of an electronic circuit substrate, and the electronic component is mounted on the electronic circuit substrate. There is a problem that the lead wire cannot be inserted into the insertion hole in such a case where this lead wire is bent.

Regarding this, for example, in a mounting device for an electronic component of PTL 1, a package of an electronic component having lead terminals is held by a holder made of elastic material. While supporting the holder with a spring member, the holder is caused to swing in the arrangement direction of the lead terminals and is caused to advance in the direction of a printed circuit board to insert the lead terminals into through holes of the printed circuit board.

In addition, in a component insertion device of PTL 2, a component to be inserted is held by a chuck, and a lead terminal is inserted into an insertion hole of a printed circuit board. At this time, if insertion failure of the lead terminal into the insertion hole is detected, the lead terminal is inserted into the insertion hole while the chuck is vibrated.

### Citation List

### Patent Literature

PTL 1: JP 07-106797 A
PTL2: JP 05-291796 A

### Summary of Invention

### Technical Problem

In each of PTL 1 and PTL 2, the lead terminal is inserted into the through hole or the insertion hole while the electronic component or the component to be inserted having the lead terminal is held and swung or vibrated. Therefore, the lead terminal is swung or vibrated and at the same time, the lead terminal is urged downward. At this time, if the lead terminal is shifted from the through hole or the insertion hole, the lead terminal is deformed.

Therefore, in the mounting device for an electronic component of PTL 1, the holder is configured of elastic material and the holder is supported by a spring member. As a result, the holder is elastically deformed; however, the holder may be obliquely inclined and insertion of the lead terminal may become difficult. In addition, in the component insertion device of PTL 2, since the chuck is vibrated while insertion failure is detected, control is complicated.

The present invention is made in order to solve the above-described problems, and an object of the present invention is to provide an electronic-component mounting device and a method for mounting an electronic component which can more easily and reliably insert a lead wire into an insertion hole of an electronic circuit substrate.

### Solution to Problem

In order to achieve the above object, an electronic-component mounting device according to an embodiment of the present invention includes: a gripping portion which grips an electronic component having a lead wire; a conveyance portion which conveys the electronic component gripped by the gripping portion onto a substrate to which an insertion hole is provided; and a swinging portion which swings the electronic component and the substrate relative to each other, the electronic component being released on the substrate from gripping by the gripping portion.

According to this configuration, the electronic component and the substrate are swung relative to each other in a state where gripping of the electronic component by the gripping portion is released and the electronic component stands by itself on the substrate. As a result, if the lead wire of the electronic component is positioned in the insertion hole of the electronic circuit substrate, the lead wire is inserted into the insertion hole by the own weight of the electronic component. Therefore, the lead wire can be more easily and more reliably inserted into the insertion hole of the electronic circuit substrate.

The electronic-component mounting device may further include a position sensor which detects the height of the electronic component. According to this, whether or not the lead wire is inserted into the insertion hole can be determined from the height of the electronic component.

In addition, in the electronic-component mounting device, the gripping portion may have a pair of surfaces that are parallel to a direction in which the lead wire extends and that face each other, and another pair of surfaces which are orthogonal to the pair of surfaces, and the swinging portion may swing the gripping portion in a state where the pair of surfaces and the other pair of surfaces surround the electronic component released from gripping by the gripping portion. At this time, a gap may be provided between outer surfaces of the electronic component released from gripping by the gripping portion and the pair of surfaces and the other pair of surfaces. As a result, the gripping portion can swing the electronic component released from gripping by the gripping portion. Then, the lead wire can be moved with respect to the insertion hole, and the lead wire can be inserted into the insertion hole.

Further, the electronic-component mounting device may further include a placement portion on which the substrate is placed, and the swinging portion may swing the placement portion. As a result, the insertion hole can be moved with respect to the lead wire, and the lead wire can be inserted into the insertion hole.

In addition, in a method for mounting an electronic component according to an embodiment, an electronic component having a lead wire is gripped, the electronic component is conveyed onto a substrate to which an insertion hole is provided, gripping of the electronic component is released on the substrate, and the electronic component and the substrate are swung relative to each other.

### Advantageous Effects of Invention

The present invention has the above-described configuration, and has the effect of being able to more easily and reliably insert the lead wire into the insertion hole of the electronic circuit substrate.

### Brief Description of Drawings

Fig. 1 is a plan view schematically illustrating an overall configuration of an example of a robot to which an electronic-component mounting device according to Embodiment 1 is applied.
Fig. 2 is a perspective view illustrating the robot of Fig. 1.
Fig. 3 is a functional block diagram schematically illustrating the configuration of a control device for a robot of Fig. 1.
Fig. 4A is a cross-sectional view schematically illustrating a state where an electronic component is gripped by a gripping portion, Fig. 4B is a cross-sectional view schematically illustrating a state where gripping of the electronic component by the gripping portion is released, and Fig. 4C is a cross-sectional view schematically illustrating a state where a lead wire of the electronic component is inserted into an insertion hole of an electronic circuit substrate.
Fig. 5 is a cross-sectional view schematically illustrating a gripping portion of an electronic-component mounting device according to Embodiment 2.
Fig. 6A is a cross-sectional view illustrating another example of the gripping portion, and Fig. 6B is a perspective view illustrating still another example of the gripping portion.

### Description of Embodiments

Hereinafter, preferred embodiments will be described with reference to the drawings. Note that in the following description, identical or equivalent elements are denoted by identical reference signs in all the drawings, and overlapping descriptions thereof will be omitted. In addition, in order to make the drawings easier to understand, each constituent is schematically illustrated, and there are cases where the shape, the dimension ratio, and the like are not illustrated accurately. Further, a direction in which a pair of arms are extended is referred to as a rightward and leftward direction, a direction parallel to the axis of a base shaft is referred to as an upward and downward direction, and a direction orthogonal to the rightward and leftward direction and the upward and downward direction is referred to as a forward and rearward direction.

### Embodiment 1

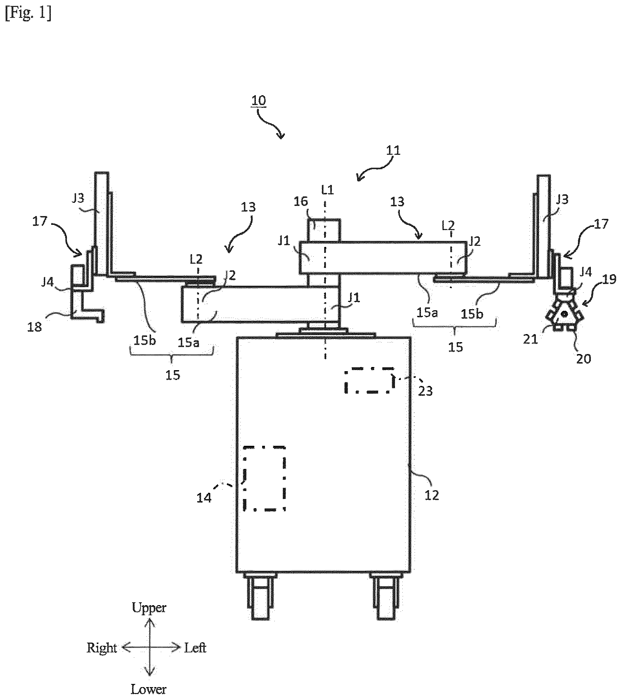

An electronic-component mounting device 10 according to the present embodiment is a device for inserting a lead wire of an electronic component into an insertion hole of an electronic circuit substrate (hereinafter referred to as a "substrate") and mounting the electronic component on the substrate. A case where the electronic-component mounting device 10 according to the present invention is applied to a robot 11 illustrated in Figs. 1 to 3 will be described. However, the electronic-component mounting device 10 is not limited to the case of being applied to the robot 11. In addition, regarding this robot 11, a horizontal articulated double arm robot will be described; however, a robot such as a horizontal articulated robot or a vertical articulated robot may be adopted.

As illustrated in Fig. 1, the robot 11 includes a carriage 12, a pair of robot arms 13, 13 (hereinafter may be simply referred to as "arms") supported by the carriage 12, and a control device 14 housed in the carriage 12. Each arm 13 is a horizontally articulated robot arm, and includes an arm portion 15, a wrist portion 17, and a hand portion 18, 19.

The arm portion 15 functions as a conveyance portion for conveying an electronic component onto the substrate and a swinging portion for swinging the electronic component. In this example, the arm portion 15 is configured of a first link 15a and a second link 15b. Note that the left and right arms 13, 13 have substantially identical structures except the hand portions 18, 19, and the right and left hand portions 18, 19 may have identical configurations or different configurations. In addition, the left and right arms 13, 13 can operate independently and can operate in association with each other.

The first link 15a of the arm portion 15 is connected to a base shaft 16 fixed to the upper surface of the carriage 12 by a rotary joint and is turnable around a rotary axis line L1 passing through the axis of the base shaft 16. The second link 15b is connected to a front end of the first link 15a by a rotary joint and is turnable around a rotary axis line L2 defined at the front end of the first link 15a. The wrist portion 17 is connected to a front end of the second link 15b by a prismatic joint and can move up and down with respect to the second link 15b. Each of the hand portions 18, 19 is connected to the wrist portion 17 by a rotary joint and is turnable around a rotary axis line.

Each arm 13 having the above configuration has joint axes J1 to J4 corresponding to the respective joints. In the arm 13, a servomotor for driving (not illustrated), an encoder (not illustrated) for detecting the rotation angle of the servomotor, and the like are provided so as to correspond to each of the joint axes J1 to J4. In addition, the rotary axis lines L1 of the first links 15a, 15a of the two arms 13, 13 are on an identical straight line, and the first link 15a of one arm 13 and the first link 15a of the other arm 13 are disposed with a difference in height therebetween in the upward and downward direction.

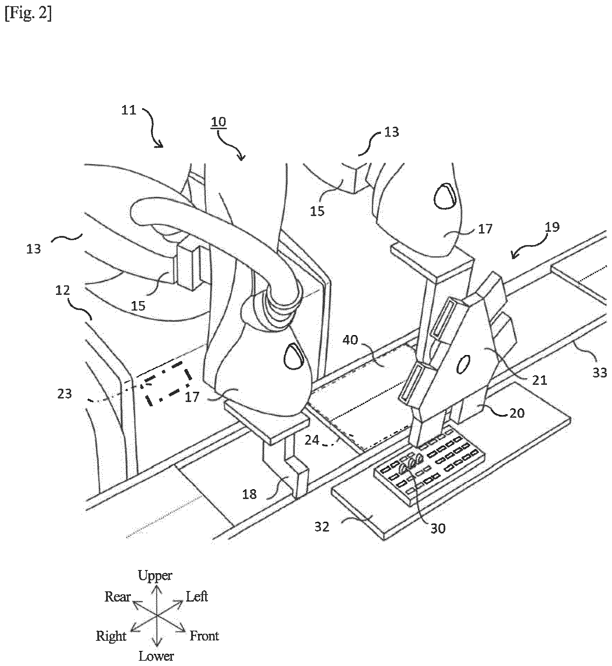

As illustrated in Fig. 2, the right hand portion 18 is configured of, for example, a transfer portion for transferring the substrate. In addition, the left hand portion 19 has a gripping portion 20 for gripping an electronic component 30, and may further have a rotary portion 21 for rotationally moving the gripping portion 20 in the upward and downward direction. Note that although only the left hand portion 19 has the gripping portion 20, it suffices that at least one of the right hand portion 18 and the left hand portion 19 has the gripping portion 20. In a case where both the right hand portion 18 and the left hand portion 19 have the gripping portions 20, the shapes of the gripping portions 20 may differ from each other.

In this embodiment, the rotary portion 21 is an equilateral triangular plate body with three corners cut off. The center axis of the rotary portion 21 extends in the direction orthogonal to the joint axis J4 of the wrist portion 17. A rotary shaft is provided with a servomotor for driving (not illustrated), an encoder (not illustrated) for detecting the rotation angle of the servomotor, and the like. As a result, the rotary portion 21 rotates clockwise or counterclockwise about the center axis and stops every time any one of the three sides becomes horizontal.

In this embodiment, for example, six gripping portions 20 are provided in the rotary portion 21. These gripping portions 20 may have identical shapes or may be different according to the shape of the electronic component 30. Two gripping portions 20 are disposed on each side of the rotary portion 21 adjacent to each other with a gap therebetween.

The gripping portion 20 has a box shape whose lower surface is opened, and has an internal space. Therefore, the inner surfaces of the gripping portion 20 are configured of an upper-side surface, a front-side surface, a rear-side surface, a right-side surface, and a left-side surface. The front-side surface, the rear-side surface, the right-side surface, and the left-side surface are parallel to the upward and downward direction and are provided so as to be vertical to the upper-side surface. The front-side surface and the rear-side surface are a pair of surfaces facing each other, and the right-side surface and the left-side surface are another pair of surfaces facing each other. The pair of surfaces configured of the front-side surface and the rear-side surface are orthogonal to the other pair of surfaces configured of the right-side surface and the left-side surface. The gripping portion 20 is opened in a direction away from the center of the rotary portion 21. As a result, when the gripping portion 20 is rotated by the rotary portion 21 and the gripping portion 20 is positioned at the bottom, an opening faces downward. Two adjacent gripping portions 20 are attached to the rotary portion 21 so that the lower surfaces thereof are on a straight line.

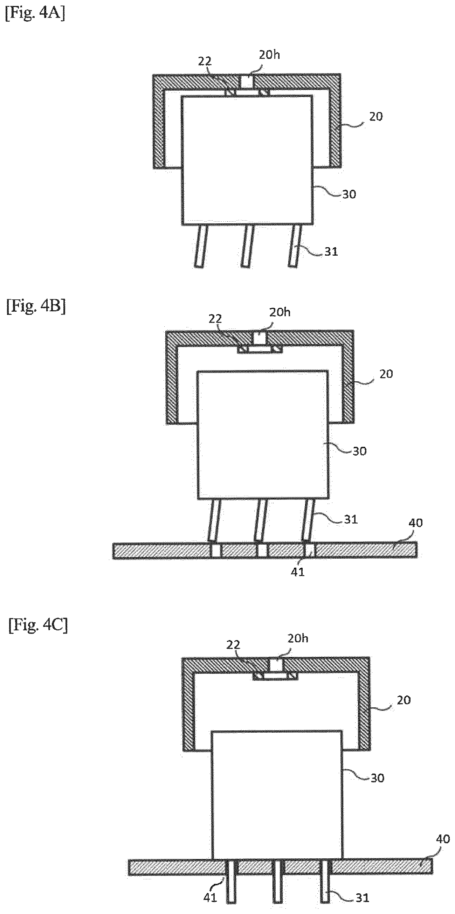

The inner surfaces of the gripping portion 20 are formed so that the internal space of the gripping portion 20 is larger than the electronic component 30. In addition, a suction device is provided in the internal space of the gripping portion 20. For example, a through hole 20h (Fig. 4A) is provided in an upper-side wall portion of the gripping portion 20, and a suction pad 22 (Fig. 4A) is provided on the inner surface of the upper-side wall portion (upper-side surface) so as to surround the through hole 20h. A suctioning pump 23 is provided on the carriage 12 or the like, and the through hole 20h and the suctioning pump 23 are connected through a pipe (not illustrated). An on-off valve (not illustrated) is provided in the pipe.

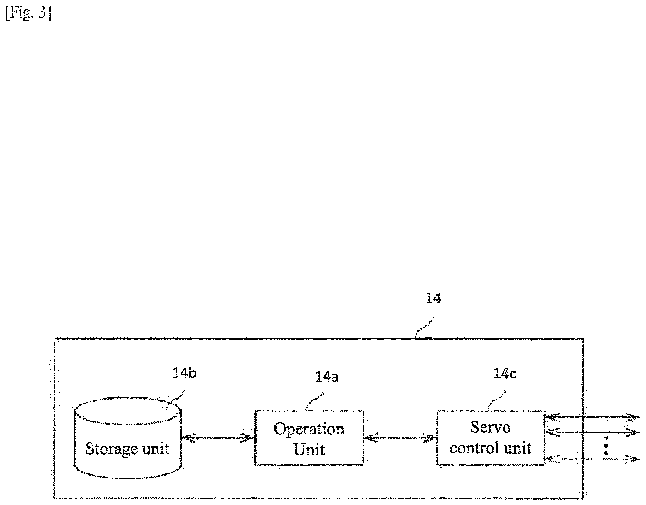

As illustrated in Fig. 3, the control device 14 includes an operation unit 14a such as a CPU, a storage unit 14b such as a ROM and a RAM, and a servo control unit 14c. The control device 14 is a robot controller including a computer such as a microcontroller. Note that the control device 14 may be configured of a single control device 14 that performs centralized control, or may be configured of a plurality of control devices 14 that cooperates with each other and performs decentralized control.

The storage unit 14b stores information such as a basic program as a robot controller, various pieces of fixed data, and the like. The operation unit 14a reads and executes software such as the basic program stored in the storage unit 14b to control various operations of the robot 11. That is, the operation unit 14a generates a control command of the robot 11 and outputs the control command to the servo control unit 14c. The servo control unit 14c is configured to control driving of the servomotors corresponding to the joint axes J1 to J4 of each arm 13 of the robot 11 according to the control command generated by the operation unit 14a.

Next, a method for mounting the electronic component 30 on the substrate 40 by the robot 11 having the above configuration will be described with reference to Figs. 2 and 4A to 4C. This method is controlled by the control device 14. Note that one gripping portion 20 out of the six gripping portions 20 will be described. Since the other gripping portions 20 are similar to this, description thereof will be omitted.

As illustrated in Fig. 2, in front of the robot 11, a work table 32 on which the electronic component 30 is disposed and a belt conveyor 33 to which the substrate 40 is transferred are provided. The electronic component 30 on the work table 32 is disposed with a lead wire 31 facing downward. The belt conveyor 33 extends in the rightward and leftward direction, and two substrates 40 disposed side by side in the forward and rearward direction are carried from the left to the right by the belt conveyor 33.

First, the robot 11 abuts the left hand portion 19 against the left end of the substrate 40 to move the substrate to the right, and places the substrate 40 on a placement portion 24 positioned in the belt conveyor 33. The placement portion 24 is slightly higher than the belt conveyor 33, and the substrate 40 placed on the placement portion 24 stops in front of the robot 11.

The robot 11 moves the left arm portion 15 forward and moves the gripping portion 20 to the work table 32. Then, the suctioning pump 23 is operated to open an on-off valve of the gripping portion 20 positioned at the bottom. As a result, as illustrated in Fig. 4A, the electronic component 30 on the work table 32 is suctioned into the gripping portion 20. At this time, since the internal space of the gripping portion 20 is larger than the electronic component 30, when the electronic component 30 is fitted in the internal space of the gripping portion 20, there is a gap between the inner surfaces of the gripping portion 20 and the outer surfaces of the electronic component 30. As a result, the electronic component 30 is smoothly inserted into the internal space of the gripping portion 20, the upper surface of the electronic component 30 is sucked to the suction pad 22, and the electronic component 30 is gripped by the gripping portion 20.

Subsequently, the rotary portion 21 is rotated so that another gripping portion 20 faces downward. Then, similarly, the on-off valve of the gripping portion 20 positioned at the bottom is opened, and the gripping portion 20 sucks and grips the electronic component 30. This is repeated for the desired number of times.

The robot 11 moves the left arm portion 15 rearward and moves the gripping portion 20 and the electronic component 30 gripped by the gripping portion 20 onto the substrate 40. At this time, the left hand portion 19 is rotated about the joint axis J4 so that the two adjacent gripping portions 20 are arranged side by side in the forward and rearward direction. As a result, the electronic components 30 can be attached to the substrates 40 arranged in the forward and rearward direction simultaneously or continuously.

As illustrated in Fig. 4B, the robot 11 closes the on-off valve of the gripping portion 20 positioned at the bottom. As a result, suctioning (gripping) by the gripping portion 20 is released, and the electronic component 30 is disposed on the substrate 40 from the internal space of the gripping portion 20 and stands by itself. Here, if the lead wire 31 of the electronic component 30 is inclined, even if the lead wire 31 is positioned above the insertion hole 41 of the substrate 40, the lead wire 31 does not pass through the insertion hole 41, and the lead wire 31 is placed on the substrate 40 and stands by itself.

The gripping portion 20 is positioned so that the height of the upper surface of the electronic component 30 is higher than the height of the lower end of the gripping portion 20. As a result, the upper portion of the electronic component 30 is still fitted in the internal space of the gripping portion 20, and is surrounded by the four inner surfaces of the gripping portion 20 with a gap therebetween. Therefore, when the left arm portion 15 repeatedly moves and swings the gripping portion 20 right and left and back and forth, the electronic component 30 is pushed by the respective inner surfaces and moves right and left and back and forth on the substrate 40. As a result, as illustrated in Fig. 4C, when the tip of the lead wire 31 matches the insertion hole 41 of the substrate 40, since gripping of the electronic component 30 by the gripping portion 20 is released, the lead wire 31 is inserted into the insertion hole 41 due to the own weight of the electronic component 30.

Then, when all the electronic components 30 are attached to the substrate 40 while the rotary portion 21 is rotated, the right hand portion 18 is abutted against the left end of the substrate 40 to move the substrate to the right. As a result, the substrate 40 is moved from the placement portion 24 to the belt conveyor 33, and the substrate 40 is conveyed by the belt conveyor 33.

According to the above configuration, after gripping of the electronic component 30 by the gripping portion 20 is released, the electronic component 30 is swung. As a result, since downward force by the gripping portion 20 does not act on the electronic component 30, deformation of the lead wire 31 of the electronic component 30 is prevented. In addition, when the tip of the lead wire 31 matches the insertion hole 41 of the substrate 40, the lead wire 31 can be inserted into the insertion hole 41 due to the own weight of the electronic component 30.

Further, the gripping portion 20 has a pair of surfaces (the front-side surface and the rear-side surface) which are parallel to the direction in which the lead wire 31 extend and which faces each other, and the other pair of surfaces (the right-side surface and the left-side surface) which are orthogonal to the pair of surfaces. In addition, a gap is provided between these surfaces and the outer surfaces of the electronic component 30. As a result, the gripping portion 20 is swung in a state where these surfaces surround the electronic component 30 released from gripping by the gripping portion 20. As a result, the electronic component 30 can be swung in the internal space of the gripping portion 20 while being supported by the surfaces of the gripping portion 20.

### Embodiment 2

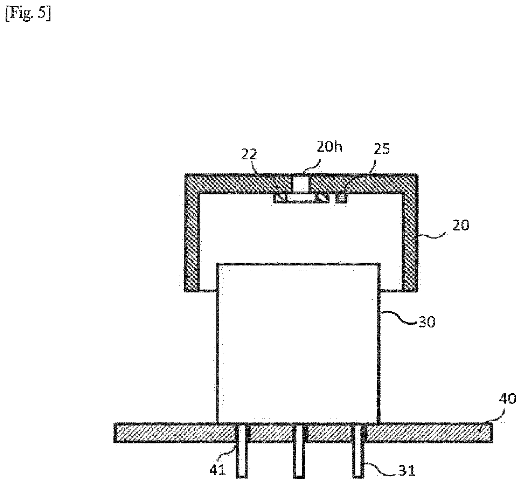

As illustrated in Fig. 5, an electronic-component mounting device 10 according to Embodiment 2 further includes a position sensor 25 which detects the height of an electronic component 30. For example, the position sensor 25 is a distance measuring sensor and is disposed near a suctioning pad in the internal space of the gripping portion 20. The position sensor 25 detects the distance to the electronic component 30 which is swung and outputs a detection signal to a control device 14 of a robot 11.

When the gripping portion 20 is swung, the gripping portion 20 is disposed at a predetermined height from the substrate 40. Therefore, from the difference between the predetermined height of the gripping portion 20 from the substrate 40 and the height from the gripping portion 20 to the electronic component 30 detected by the position sensor 25, the height of the electronic component 30 with respect to the substrate 40 can be detected. In addition, the height of the electronic component 30 from the substrate 40 when a lead wire 31 is inserted into an insertion hole 41 of the substrate 40 is previously obtained. A threshold is set according to this height.

Therefore, while the gripping portion 20 is swung or immediately thereafter, the position of the electronic component 30 is detected by the position sensor 25. If the height of the electronic component 30 with respect to the substrate 40 obtained from this detection result is larger than the threshold, it is determined that the lead wire 31 is not inserted into the insertion hole 41. As a result, by further swinging the gripping portion 20, the lead wire 31 can be further reliably inserted into the insertion hole 41. In contrast, if the height of the electronic component 30 with respect to the substrate 40 is equal to or less than the threshold, it is determined that the lead wire 31 is inserted into the insertion hole 41. As a result, swinging of the gripping portion 20 is stopped.

Note that in the above, it is determined whether or not the lead wire 31 is inserted into the insertion hole 41 by comparing the height of the electronic component 30 with respect to the substrate 40 and the threshold. Regarding this, determination may be made by comparing the height of the electronic component 30 with respect to the gripping portion 20 and the threshold.

### Embodiment 3

In the electronic-component mounting device 10 according to each of Embodiments 1 and 2, the arm portion 15 is the swinging portion, and the left arm portion 15 swings the electronic component 30 by the gripping portion 20. Regarding this, the swinging portion may be any as long as the swinging portion relatively swings the electronic component 30 and the substrate 40. For example, in an electronic-component mounting device 10 according to Embodiment 3, a swinging portion (not illustrated) swings a placement portion 24. In this case, the swinging portion is provided on the placement portion 24, and repeatedly moves a substrate 40 back and forth and right and left with respect to an electronic component 30.

### Other Embodiments

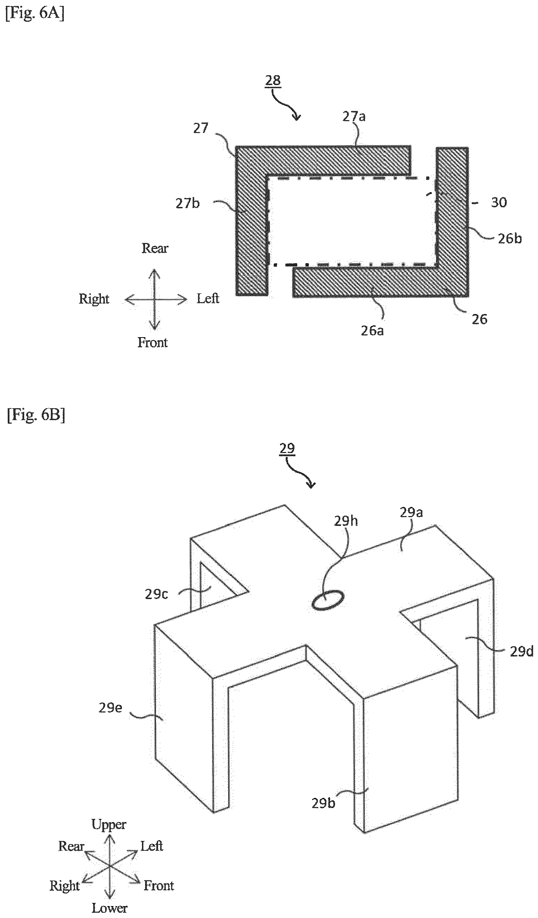

In each of all the above embodiments, the gripping portion 20 having a box shape with the lower surface opened and provided with the suction device is used; however, the shape and the gripping method of the gripping portion 20 is not limited to this. For example, as illustrated in Fig. 6A, a gripping portion 28 configured of a first member 26 and a second member 27 may be adopted.

The first member 26 of the gripping portion 28 is formed in an L shape in a plane orthogonal to the upward and downward direction and has a front-side wall portion 26a extending rightward from a corner and a left-side wall portion 26b extending rearward from the corner. The second member 27 is formed in an L shape in the plane orthogonal to the upward and downward direction and has a rear-side wall portion 27a extending leftward from a corner and a right-side wall portion 27b extending forward from the corner.

The first member 26 and the second member 27 are disposed so that the inner surface of the front-side wall portion 26a (front-side surface) and the inner surface of the rear-side wall portion 27a (rear-side surface) face each other and are parallel to each other, and the inner surface of the left-side wall portion 26b (left-side surface) and the inner surface of the right-side wall portion 27b (right-side surface) face each other and are parallel to each other. Both the first member 26 and the second member 27 are movable in the forward and rearward direction and the rightward and leftward direction. Therefore, the electronic component 30 is sandwiched between the front-side wall portion 26a and the rear-side wall portion 27a in the forward and rearward direction so that the front-side surface is in contact with the front surface of the electronic component 30 and the rear-side surface is in contact with the rear surface of the electronic component 30. In addition, the electronic component 30 is sandwiched between the left-side wall portion 26b and the right-side wall portion 27b in the rightward and leftward direction so that the left-side surface is in contact with the left surface of the electronic component 30 and the right-side surface is in contact with the right surface of the electronic component 30. As a result, the gripping portion 28 can grip the electronic component 30.

In contrast, the front-side wall portion 26a and the rear-side wall portion 27a are separated from each other in the forward and rearward direction so that the gap between the front-side surface and the rear-side surface is increased, and the left-side wall portion 26b and the right-side wall portion 27b are separated from each other in the rightward and leftward direction so that the gap between the left-side surface and the right-side surface is increased. As a result, gripping of the electronic component 30 by the gripping portion 28 is released. At this time, a gap is provided between the outer surfaces of the electronic component 30 and the front-side surface, the rear-side surface, the left-side surface, and the right-side surface of the gripping portion 28.

In addition, a gripping portion 29 illustrated in Fig. 6B may be used. This gripping portion 29 has a cross-shaped upper-side wall portion 29a, and a front-side wall portion 29b, a rear-side wall portion 29c, a left-side wall portion 29d and a right-side wall portion 29e which each have a rectangular shape. The front-side wall portion 29b extends downward from the front end of the upper-side wall portion 29a, the rear-side wall portion 29c extends downward from the rear end of the upper-side wall portion 29a, the left-side wall portion 29d extends downward from the left end of the upper-side wall portion 29a, and the right-side wall portion 29e extends downward from the right end of the upper-side wall portion 29a.

The inner surface of the front-side wall portion 29b (front-side surface) and the inner surface of the rear-side wall portion 29c (rear-side surface) face each other and are parallel to each other, and the inner surface of the left-side wall portion 29d (left-side surface) and the inner surface of the right-side wall portion 29e (right-side surface) face each other and are parallel to each other. An internal space of the gripping portion 29 is formed so that a gap is provided between the outer surfaces of the electronic component 30 and the front-side surface, the rear-side surface, the left-side surface, and the right-side surface of the gripping portion 29.

In addition, a through hole 29h is provided at the center of the upper-side surface, and a suctioning pump 23 (Fig. 1) is connected to the through hole 29h through a pipe. By opening an on-off valve provided in this pipe, the electronic component 30 is gripped by the gripping portion 29. By closing the on-off valve, gripping of the electronic component 30 by the gripping portion 29 is released.

In addition, in each of all the above embodiments, the electronic component 30 is provided with the three lead wires 31; however, the number of lead wires 31 is not limited thereto, and may be one or more.

From the above description, many improvements and other embodiments of the present invention are apparent to those skilled in the art. Therefore, it is to be understood that the above description is to be construed as illustrative only and is provided for the purpose of teaching those skilled in the art the best mode of carrying out the present invention. It is possible to substantially change the details of the structure and/or function of the present invention without departing from the spirit of the present invention.

### Industrial Applicability

The present invention is useful for an electronic-component mounting device, a method for mounting an electronic component, and the like which can more easily and reliably insert a lead wire into an insertion hole of an electronic circuit substrate.

### Reference Signs List

- 10: electronic-component mounting device
- 11: robot
- 15: arm portion (conveyance portion, swinging portion)
- 20: gripping portion
- 24: placement portion
- 25: position sensor

## Claims

1. An electronic-component mounting device comprising:
a gripping portion which grips an electronic component having a lead wire;
a conveyance portion which conveys the electronic component gripped by the gripping portion onto a substrate to which an insertion hole is provided; and
a swinging portion which swings the electronic component and the substrate relative to each other, the electronic component being released on the substrate from gripping by the gripping portion.

2. The electronic-component mounting device according to claim 1, further comprising a position sensor which detects a height of the electronic component.

3. The electronic-component mounting device according to claim 1 or 2,
wherein the gripping portion has a pair of surfaces that are parallel to a direction in which the lead wire extends and that face each other, and another pair of surfaces which are orthogonal to the pair of surfaces, and
wherein the swinging portion swings the gripping portion in a state where the pair of surfaces and the other pair of surfaces surround the electronic component released from gripping by the gripping portion.

4. The electronic-component mounting device according to claim 3, wherein a gap is provided between outer surfaces of the electronic component released from gripping by the gripping portion and the pair of surfaces and the other pair of surfaces.

5. The electronic-component mounting device according to claim 1 or 2, further comprising a placement portion on which the substrate is placed,
wherein the swinging portion swings the placement portion.

6. A method for mounting an electronic component comprising:
gripping an electronic component having a lead wire;
conveying the electronic component onto a substrate to which an insertion hole is provided;
releasing gripping of the electronic component on the substrate; and
swinging the electronic component and the substrate relative to each other.
